# DEMANDE DE BREVET EUROPEEN

(11) **EP 1 162 470 A1**
(43) Date de publication de la demande: **12.12.2001**
(21) Numéro de dépôt: 01470016.5
(22) Date de dépôt: 05.06.2001
(51) Int. Cl.: G01R 27/02, G01R 1/36

(54) **Appareil de test des contrôleurs d'isolement de réseaux électriques**

(30) Priorité: 09.06.2000 FR 0007392
(71) Demandeur: Mengin, Florent, 88000 Dogneville (FR)
(72) Inventeur: Mengin, Florent, 88000 Dogneville (FR)

(57) **Abrégé**

L'invention concerne un appareil de test du bon fonctionnement des contrôleurs d'isolement raccordés sur les réseaux électriques sous tension fonctionnant selon le schéma I T (réseau isolé de la terre).

Ledit appareil est destiné à être raccordé entre le réseau de protection et un point quelconque du réseau électrique sous tension concerné afin de provoquer un défaut d'isolement apte à activer l'alarme du contrôleur d'isolement testé.

Suivant l'invention ledit appareil comporte entre autres, des résistances de test (25, 26, 27, 28, 29, 30) chacune de puissance nominale moindre que celle qu'elle devrait posséder pour subir sans dommage les tests sous la tension nominale de l'appareil de test. Lesdites résistances sont déconnectées sur information d'un organe de détection ayant détecté qu'un seuil prédéterminé de tension ou de température est atteint.

Ledit appareil comporte également un sélecteur et un organe de pontage des résistances de test dont les organes de puissance sont de tensions nominales inférieures à la tension nominale de l'appareil de test et qui fonctionnent sans danger pour les matériels, le réseau électrique ou l'utilisateur grâce à des modes particuliers de mise en oeuvre des matériels qui les constituent.

## Description

La présente invention concerne un appareil de test du bon fonctionnement des contrôleurs d'isolement raccordés sur les réseaux électriques sous tension.

Globalement, dans chaque installation électrique fonctionnant selon le schéma I T (réseau isolé de la terre), l'isolement par rapport à la terre du réseau de la dite installation est réglementairement contrôlé en permanence par un contrôleur d'isolement.

Le dit contrôleur permet de mesurer la résistance ohmique entre les tous points du réseau électrique sous tension et le circuit de protection (P E) du dit réseau, et de comparer celle-ci a un seuil, réglable en général, qui équipe le dit contrôleur.

Si cette résistance, appelée résistance d'isolement, devient inférieure au seuil réglé sur le contrôleur d'isolement, celui-ci active une alarme visuelle (voyant rouge habituellement) et/ou sonore.

Le test du bon fonctionnement de ces contrôleurs d'isolement est usuellement effectué à l'aide de résistances de test qu'un opérateur doit connecter entre le réseau électrique sous tension de l'installation et le réseau de protection du dit réseau (PE) afin de créer un défaut d'isolement.

La valeur ohmique de ces résistances est alors choisie en dessous du seuil de réglage de l'alarme du contrôleur d'isolement, et le bon fonctionnement de ce dernier est avéré lorsque son alarme visuelle ou sonore est activée.

Les dites résistances sont connectées entre le réseau de protection d'une part, et un point du réseau électrique sous tension d'autre part ; C'est à dire sur le neutre lorsque celui-ci existe et est accessible ou alors sur une des phases du réseau électrique sous tension lorsque ce dernier est de type "alternatif, ou sur l'une des deux polarités lorsque le réseau électrique est de type "continu".

Les dites résistances subissent alors une tension relativement élevée lorsque le réseau électrique sous tension est déjà le siège d'un défaut d'isolement sur une des phases(dans le cas d'un réseau électrique de type "alternatif')ou sur une des deux polarités(dans le cas d'un réseau électrique de type "continu"), que le contrôleur d'isolement du dit réseau est défectueux et ne signale pas le problème, et que la connexion au réseau des résistances de test est effectuée sur une phase ou une polarité qui n'est pas affectée par le dit défaut.

Il suffira d'indiquer à titre d'exemple que sur un réseau triphasé 500 Volts alternatifs, une résistance connectée entre une phase du dit réseau et le réseau de protection est soumise à une tension d'environ 500 Volts alternatifs à ses bornes si un défaut d'isolement affecte le réseau électrique sur une des deux autres phases.

Si alors cette résistance possède une valeur ohmique d'environ 450 ohms afin de vérifier le bon fonctionnement d'un contrôleur d'isolement dont le seuil d'alarme est réglé à 500 Ohms (valeur fréquemment rencontrée sur ce genre de matériel), sa puissance nominale devrait être d'environ 555 Watts afin de subir sans dommage le test pendant une durée quelconque, c'est à dire en service continu dans le pire des cas. Une résistance de ce type est volumineuse et ne s'intègre pas facilement dans un appareil de test portable.

Le dispositif selon l'invention permet avantageusement de remédier à cet inconvénient. Il comporte en effet, selon une première caractéristique, des résistances de test de puissances nominales inférieures aux puissances qu'elles devraient dissiper pour subir sans dommage leur mise sous tension, à la tension nominale du dispositif selon l'invention, en service continu.

Leur utilisation permet malgré tout d'effectuer le test des contrôleurs d'isolement pendant un temps suffisant pour juger du bon fonctionnement de ces derniers, sans causer aucun dommage aux équipements qui composent le dispositif selon l'invention, et dans des conditions de sécurité satisfaisantes pour l'utilisateur. Ces résistances de moindre puissances nominales sont moins volumineuses et moins coûteuses que d'autres de puissances nominales permettant un fonctionnement en service continu sous la tension nominale du dispositif selon l'invention. Elles permettent de s'intégrer plus facilement dans un appareil de tests portable. Cet avantage est obtenu grâce à l'installation d'un organe de détection de seuil prédéterminé préférentiellement de température haute et par exemple placé à proximité de ces résistances de test et qui provoque leur mise hors tension avant qu'elles ne subissent des dommages irréversibles, le temps disponible avant action de cet organe étant suffisant pour apprécier le bon fonctionnement du contrôleur d'isolement testé. Cette mise hors tension peut être obtenue soit en faisant agir le dit organe sur des moyens de pontage qui équipent le dispositif selon l'invention, soit en utilisant le dit organe lui-même en moyen de déconnexion des résistances de test s'il présente les caractéristiques nécessaires à cet égard.

Selon une deuxième caractéristique, des modes particuliers d'utilisation de matériels de tension nominale inférieure à la tension nominale du dispositif selon l'invention sont utilisés afin qu'ils fonctionnent sans dommage pour eux même ou leur environnement et dans des conditions de sécurité satisfaisantes sous la tension nominale du dispositif selon l'invention.

Ainsi, les moyens de pontage précédemment cités, qui sont aptes à connecter ou déconnecter les résistances de tests sélectionnées aux deux bornes de raccordement du dispositif selon l'invention, peuvent avantageusement être réalisés à l'aide, entre autres, d'un relais doté de contacts de puissance dont la tension nominale de chacun peut être inférieure à la tension nominale du dispositif selon l'invention à condition que les dits contact soient reliés électriquement en série, le bon fonctionnement du système étant obtenu lorsque la somme des tensions nominales de chacun des contacts est supérieure ou égale à la tension nominale du dispositif selon l'invention, et lorsque la rigidité diélectrique entre les dits contacts est nettement supérieure à la tension nominale du dispositif selon l'invention, l'isolement de l'opérateur par rapport au relais étant obtenu en intégrant ce dernier dans un boîtier en matériau isolant par exemple.

Ces moyens de pontage peuvent également être réalisés à l'aide de plusieurs relais excités et désexcités simultanément et dotés de contacts de puissance dont la tension nominale de chacun peut être inférieure à la tension nominale du dispositif selon l'invention à condition que ces dits contacts soient reliés électriquement en série, le bon fonctionnement du système étant obtenu lorsque la somme des tensions nominales de chacun de ces contacts est supérieure ou égale à la tension nominale du dispositif selon l'invention, et lorsque la rigidité diélectrique entre contacts d'un même relais est nettement supérieure à la tension nominale du dispositif selon l'invention divisée par le nombre de relais qui composent ces moyens de pontage, l'isolement de l'opérateur par rapport au relais étant obtenu en intégrant ce dernier dans un boîtier en matériau isolant par exemple. Cette dernière solution permet d'améliorer et de sécuriser davantage le pouvoir de coupure des moyens de pontage lorsque la somme des tensions nominales de chaque contact est nettement supérieure à la tension nominale du dispositif selon l'invention.

Selon une troisième caractéristique, le sélecteur qui peut équiper le dispositif selon l'invention et qui permet de sélectionner une résistance de test de valeur ohmique appropriée à l'examen à réaliser peut avantageusement être de tension nominale inférieure à la tension nominale du dispositif selon l'invention et être manoeuvré sous la tension nominale de ce dernier à condition qu'il soit doté de plusieurs contacts à action simultanée pour chaque position et que ces dits contacts à action simultanée de chaque position soient raccordés électriquement en série, le bon fonctionnement du système étant obtenu lorsque la somme des tensions nominales de chacun des contacts à action simultanée de chaque position est supérieure ou égale à la tension nominale du dispositif selon l'invention, et lorsque la rigidité diélectrique entre les contacts et le châssis d'une part et entre contacts d'autre part est nettement supérieure à la tension nominale du dispositif selon l'invention, l'isolement de l'opérateur par rapport au sélecteur étant obtenu en intégrant ce dernier dans un boîtier en matériau isolant et en utilisant un bouton de commande du sélecteur en matériau isolant par exemple.

Selon une variante de cette troisième caractéristique, le sélecteur dont il est question peut avantageusement être de tension nominale inférieure à la tension nominale du dispositif selon l'invention et équipé d'un seul contact par position du sélecteur à condition que la manoeuvre de ce dernier soit proscrite lorsque qu'il est sous tension, et que la rigidité diélectrique entre les dits contacts et le châssis d'une part et entre contacts d'autre part soit nettement supérieure à la tension nominale du dispositif selon l'invention, l'isolement de l'opérateur par rapport au sélecteur étant obtenu en intégrant ce dernier dans un boîtier en matériau isolant et en utilisant un organe de manoeuvre du sélecteur en matériau isolant par exemple.

Selon une quatrième caractéristique, le dispositif selon l'invention peut également comporter un organe de mise en service du dispositif permettant de mettre en oeuvre les moyens de pontage, un organe de commande de la connexion aux bornes de raccordement du dispositif selon l'invention via les moyens de pontage des résistances de test sélectionnées, un organe de commande de la déconnexion des résistances de test sélectionnées aux bornes de raccordement du dispositif selon l'invention via les moyens de pontage, un organe de signalisation de la mise en service du dispositif permettant de mettre en oeuvre les moyens de pontage, un organe de signalisation de la connexion des résistances de test via les moyens de pontage aux bornes de raccordement du dispositif selon l'invention, un organe de signalisation de la limite haute de température atteinte par les résistances de test.

Par ailleurs l'art antérieur connaît les documents US 5 853 908 et JP 08 029 460.

Le document US 5 853 908 décrit un fusible thermique assurant la protection des piles en provoquant l'arrêt de leur charge. La résistance activant ce fusible n'est mise sous tension que lorsque la tension aux bornes des piles et trop élevée, et elle n'est pas mise en danger car elle est calibrée pour supporter cette tension.

Au contraire la ou les résistances du dispositif selon l'invention sont mises hors tension par le fusible car elles sont sous dimensionnées par rapport à la tension qui leur est appliquée.

Le document JP 08 029460 concerne un dispositif de test de dipôles à effet de champs équipé d'un organe de détection de seuil de tension haute par rapport à un seuil préréglé. Ce dispositif a pour but d'activer un système de signalisation du dipôle défectueux, il ne provoque pas la déconnexion du dipôle testé et de la résistance connectée en série, qui ne sont d'ailleurs pas en danger même lorsque le dipôle testé est défectueux.

Un appareil de test conforme à l'invention comporte les caractéristiques énoncées précédemment et se démarque des documents cités ci-dessus.

Plus précisément l'invention consiste en un appareil de test du bon fonctionnement des contrôleurs d'isolement raccordés sur les réseaux électriques sous tension, destiné à être raccordé par l'intermédiaire de ses des deux bornes de connexion au réseau de protection d'une part et à un quelconque point du réseau électrique sous tension concerné d'autre part, et équipé entre autre de résistances de test connectables entre les bornes du dit appareil de test afin de créer un défaut d'isolement apte à exciter l'alarme du contrôleur d'isolement testé, caractérisé en ce que les dites résistances de test sont de puissances nominales inférieures aux puissances qu'elles devraient dissiper pour subir sans dommage les mise sous tension nominale de l'appareil de test entre le réseau électrique et le réseau de protection pendant une durée quelconque, c'est à dire en service continu, et protégées contre ces dits dommages grâce à un organe de détection de seuil prédéterminé placé à proximité de celles-ci apte à provoquer leur déconnexion d'entre les bornes de l'appareil de test avant qu'elles ne subissent des dommages irréversibles, le temps disponible avant action de cet organe étant suffisant pour apprécier si le contrôleur d'isolement testé active l'alarme prévue en cas de défaut d'isolement sur le réseau électrique.

Le seuil prédéterminé est, comme le mode de réalisation non limitatif décrit, une limite de température haute, mais il peut être également une limite de tension haute.

Les caractéristiques et avantages du dispositif selon l'invention ressortiront de la description qui va suivre, à titre d'exemple, en référence aux dessins schématiques sur lesquels :

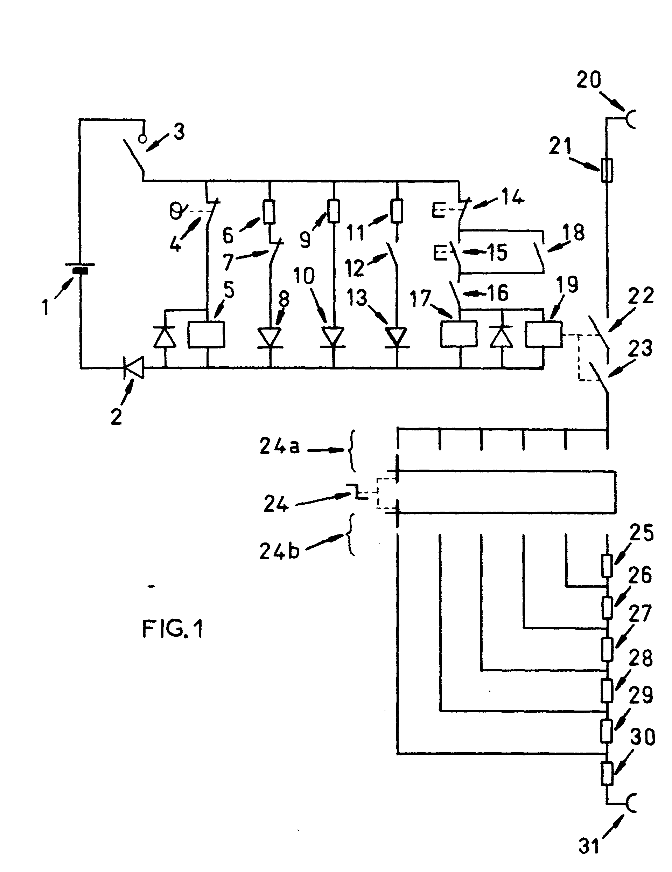

- la figure 1 est le schéma électrique de l'appareil de test selon un mode préféré de réalisation non limitatif de l'invention.
- la figure 2 est une vue en plan de l'appareil de test de la figure 1, vu de dessus.
- la figure 3 est une vue en plan de l'appareil de test de la figure 1, suivant la flèche I de la figure 2.
- la figure 4 est une vue en plan de l'appareil de test de la figure 1, suivant la Flèche II de la figure 2.
- la figure 5 est une vue en coupe de l'appareil de test de la figure 1, suivant la Coupe AA signalée sur la figure 3.
- la figure 6 est le détail de résistances de tests et du thermostat sur leur plaque support dans l'appareil de test de la figure 1, suivant la Flèche III de la figure 5.
- la figure 7 est le détail de résistances de test sur leur plaque support dans l'appareil de test de la figure 1, suivant la Flèche IV de la figure 5.
- la figure 8 est le détail du circuit électronique où sont soudés des composants, suivant la Flèche III de la figure 5.

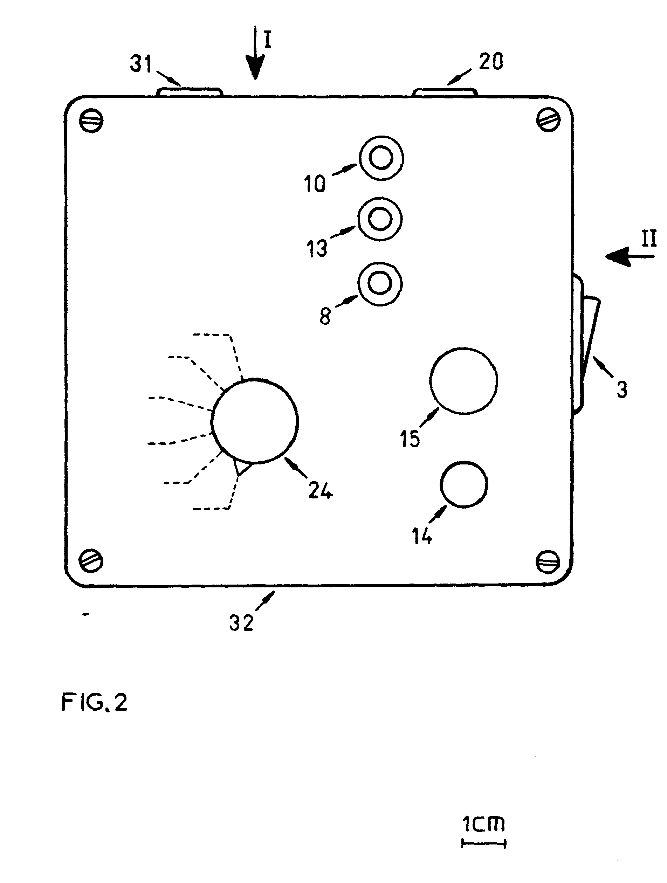

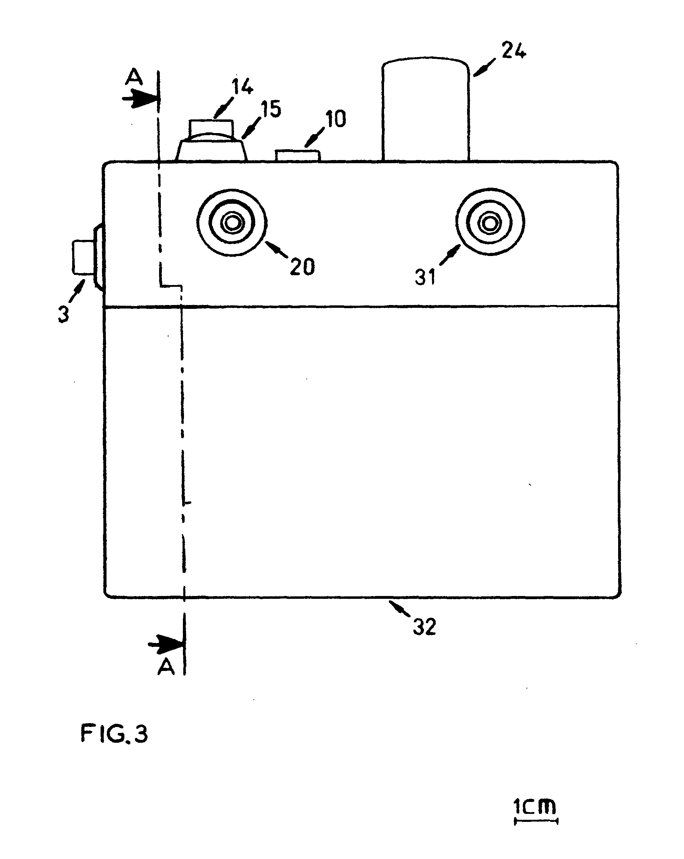

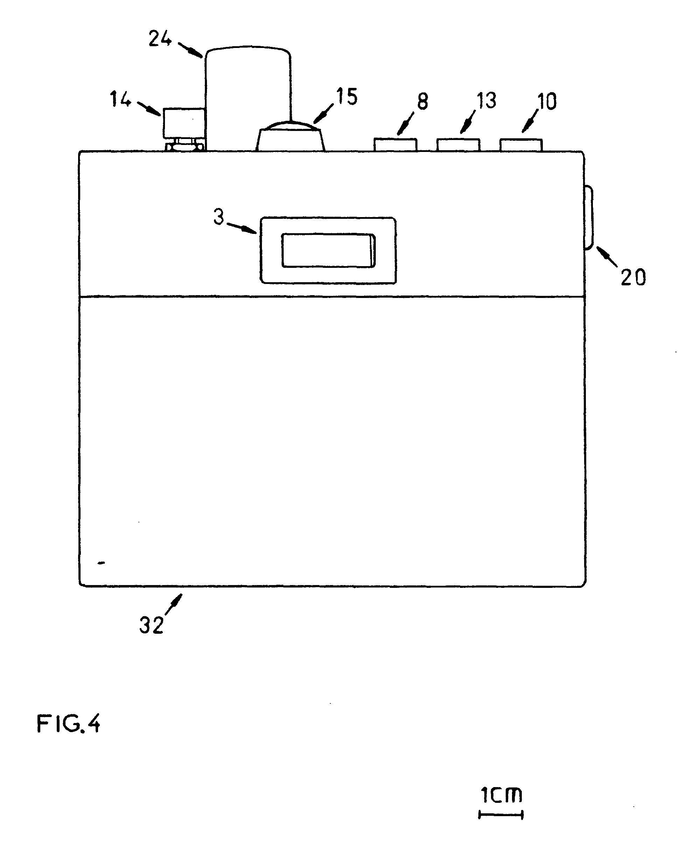

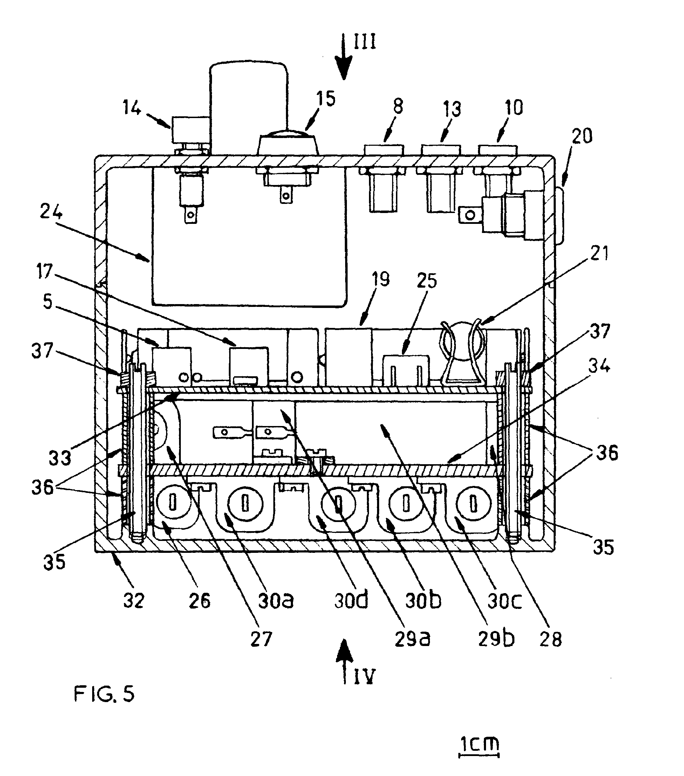

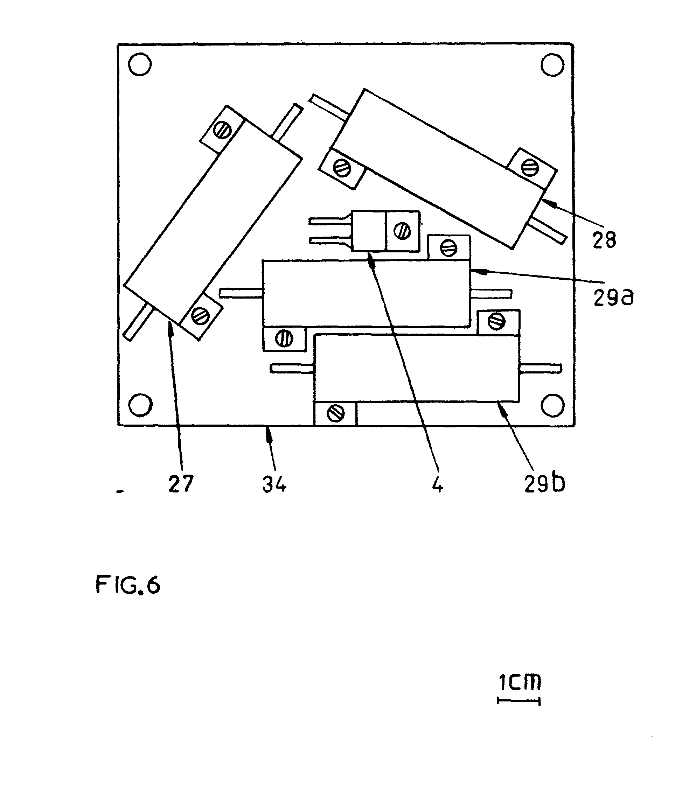

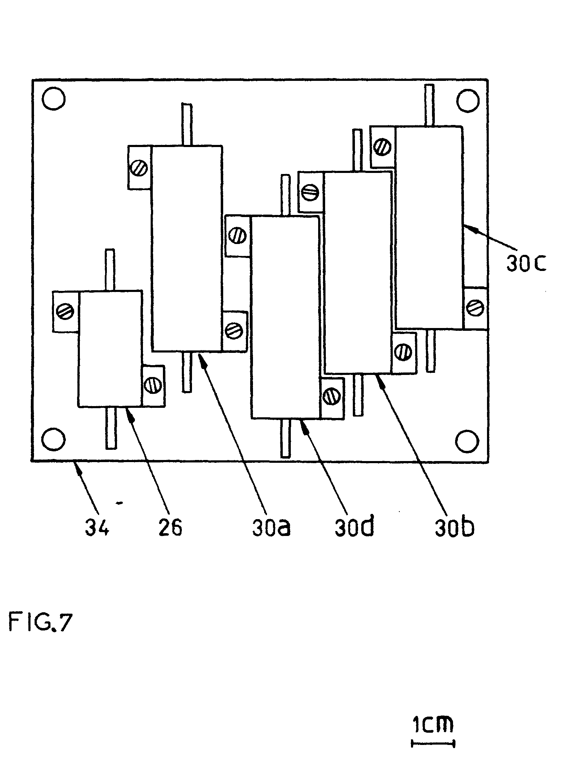

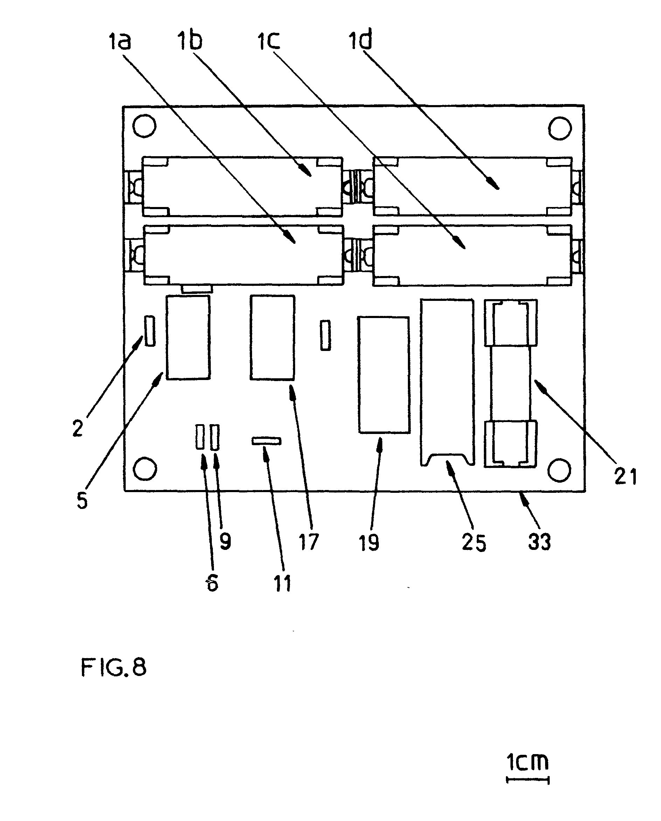

Les liaisons électriques entre les différents organes n'ont pas étés représentés sur les figures 2 à 8.

La présente invention a d'une manière générale pour objet un appareil de test permettant de vérifier le fonctionnement des contrôleurs d'isolement connectés sur des réseaux électriques, sous tension, fonctionnant selon le schéma I T (réseau isolé de la terre) et de tensions nominales jusqu'à 500 Volts alternatifs et 220 Volts continus dans l'exemple de réalisation présenté.

Il est destiné à être raccordé entre le neutre, une polarité, ou une phase quelconque du réseau électrique sous tension et le réseau de protection (P E) du dit réseau grâce aux bornes (20) et (31).

L'exemple de réalisation présenté comporte six calibres de résistances de test : 450 ohms, 890 ohms, 2100 ohms, 4300 ohms, 9000 ohms et 42 000 ohms. Ces différents calibres sont sélectionnables depuis le sélecteur (24) et permettent d'adapter la résistance de test au contrôleur d'isolement dont l'opérateur désire vérifier le bon fonctionnement. Ce sélecteur (24) a été choisi de tension nominale 250 Volts alternatifs - 220 Volts continus et équipé de douze contacts, chacun de tension nominale de 250 Volts alternatifs - 220 Volts continus, les deux contacts à action simultanée de chacune des six positions du sélecteur (24) étant raccordés électriquement en série afin de permettre de manoeuvrer ce sélecteur sans dommage pour les contacts lorsque l'appareil selon l'invention est raccordé aux bornes (20) et (31) à une source électrique de tension jusqu'à 500 Volts alternatifs ou 220 Volts continus. Cette dernière situation est facilitée grâce au fait que l'intensité qui traverse les contacts du sélecteur (24) n'est pas de caractère inductive ou capacitive, mais presque purement résistive.

Selon une variante non schématisée, les six contacts (24b) du sélecteur (24) peuvent être raccordés en sélection des différentes résistances de test (25, 26, 27, 28, 29, 30),sous la tension nominale 500 Volts alternatifs ou 220 Volts continus de l'appareil selon l'invention, et l'ensemble des six contacts (24a) raccordés en parallèle peut être raccordé en série avec le bouton poussoir (14) afin de déconnecter les résistances de test des bornes (20) et (31) grâce aux contacts (22) et (23) prévus à cet effet.

L'ensemble des organes de commande des organes électriques (3, 14, 15, 24) et de signalisation (8, 10, 13), ainsi que le boîtier (32) de l'appareil de test selon l'invention sont choisis en matériau isolant afin de garantir un isolement satisfaisant de l'opérateur par rapport au réseau électrique sous tension.

Les deux contacts (22) et (23) de connexion ou déconnexion aux bornes (20) et (31) des résistances de test (25) à (30) sont partie intégrante du relais (19).

Ce relais miniature est équipé, entre autre, de deux contacts (22) et (23) qui sont chacun de tension nominale 250 Volts alternatifs - 220 Volts continus - Rigidité diélectrique 1000 V alternatifs.

Ces deux contacts, actionnés simultanément, sont raccordés électriquement en série afin qu'ils connectent ou déconnectent sans dommage pour eux même ou pour les matériels environnants les résistances de test sélectionnées aux bornes (20) et (31) sous une tension jusqu'à 500 Volts alternatifs ou 220 V continus. Cette situation est facilitée grâce au fait que l'intensité qui traverse les contacts (22) et (23) du relais (19) n'est pas de caractère inductive ou capacitive, mais presque purement résistive.

Ce relais (19) est installé dans le boîtier (32) en matériau isolant afin de garantir un isolement satisfaisant de l'opérateur par rapport au réseau électrique sous tension.

Selon une variante non schématisée, le relais (19) et ses deux contacts (22) et (23) peut être doublé afin de sécuriser davantage le pouvoir de coupure des moyens de pontage. Ainsi le relais supplémentaire serait excité simultanément avec le relais (19), et les deux contacts de ce relais supplémentaire seraient raccordés en série avec les deux contacts (22) et (23).

L'appareil de contrôle suivant l'invention permet donc avantageusement d'être fabriqué avec du matériel de moindre tension nominale que la tension nominale de ce premier et de garantir malgré tout le bon fonctionnement de celui-ci dans des conditions de sécurité satisfaisantes pour l'opérateur et le réseau électrique sous tension concerné.

Le dispositif selon l'invention présenté en exemple est équipé, entre autre, d'un circuit électronique qui permet de piloter la connexion ou la déconnexion des résistances de test sélectionnées aux bornes (20) et (31).L'énergie nécessaire au fonctionnement du dit circuit électronique est fournie par un générateur constitué de quatre piles (1a,1b,1c et 1d) de type LR6 (ou A A), chacune de tension nominale 1,5 Volts, connectées électriquement en série.

La fermeture de l'interrupteur (3) met le circuit électronique en service et l'organe de visualisation (10) se trouve excité. De plus, le relais (5), qui agit sur le contact à ouverture (7) et le contact a fermeture (16), est actionné à condition que la température des résistances de test (25) à (30) soit inférieure au seuil de déclenchement de l'organe de détection de seuil de température haute (4), qui se trouve être un thermostat équipé d'un contact électrique dans l'exemple présenté. Lorsqu'une pression est alors exercée par l'opérateur sur le bouton poussoir (15), équipé d'un contact à fermeture, les relais (17) et (19) sont excités. Le relais (17) agit alors sur le contact a fermeture (18) qui assure l'auto alimentation des deux relais (17) et (19), et agit également sur le contact a fermeture (12) afin d'exciter l'organe de visualisation (13). Le relais (19), lui, agit sur les deux contacts (22) et (23) connectés électriquement en série qui assurent la connexion des résistances de test, choisies grâce au sélecteur (24), aux bornes (20) et (31).

Selon une variante non décrite, l'organe de détection de seuil de température haute peut également être un fusible thermique ou tout autre dispositif électronique permettant de détecter une élévation de température des résistances de test.

Si le test de fonctionnement d'un contrôleur d'isolement installé sur une installation électrique sous tension met en danger une quelconque des résistances de test (25) à (30), le thermostat (4) détecte une surchauffe et désactive le relais (5), qui agit alors sur l'ouverture du contact (16) afin de désexciter les relais (17) et (19), et sur la fermeture du contact (7) afin d'exciter l'organe de visualisation (8) qui signale à l'opérateur que la limite haute de température est atteinte.

La désexcitation du relais (19) provoque alors l'ouverture des deux contacts (22) et (23) et assure ainsi la mise hors tension des résistances de test 25 à 30, c'est à dire leur déconnexion des bornes (20) et (31), avant que tout ou partie d'entre elles ne subisse des dommages irréversibles.

La désexcitation du relais (17) provoque quant à lui l'ouverture du contact (18) d'auto alimentation des relais (17) et (19) et l'ouverture du contact (12) qui provoque la désexcitation de l'organe de visualisation (13) qui signale que les résistances de test ne sont plus connectées aux bornes (20) et (31). Les résistances de test (25) à (30) ne peuvent alors plus être connectées aux bornes (20) et (31) par les contacts (22) et (23) du relais (19) tant que la température de ces premières ne sera pas redescendue sous le seuil de fermeture du contact du thermostat (4). A tout moment, l'opérateur peut exercer une pression sur le bouton poussoir (14), équipé d'un contact à ouverture, afin de provoquer la désexcitation des relais (17) et (19) et par-là même la déconnexion des résistances de test (25 à 30) des bornes (20) et (31).

Le dispositif selon l'invention présenté en exemple est doté d'un fusible (21) de calibre 2 Ampères - 500 Volts à très haut pouvoir de coupure installé entre le contact (22) du relais (19) et la borne (20), au plus près de cette dernière, afin de protéger le réseau électrique sous tension sur lequel est raccordé le dispositif selon l'invention, ou le dispositif selon l'invention lui-même, contre tout problème de dysfonctionnement de celui-ci.

Le raccordement électrique entre les organes (20 à 31) est réalisé dans cet exemple de réalisation, à l'aide de fil de câblage isolé au silicone et de tension nominale 1000 Volts afin de réduire au maximum les risques de claquage d'isolation entre parties des circuits du dispositif selon l'invention. De plus, une isolation supplémentaire est confectionnée pour la liaison entre la borne (20) et le fusible (21) afin de limiter au maximum le risque de claquage d'isolation entre cette liaison et le reste des circuits du dispositif selon l'invention ; Dans l'exemple de réalisation présenté, celle-ci est réalisée à l'aide d'une gaine thermorétractable qui recouvre l'isolation de la liaison électrique concernée et sa soudure à la borne (20).

En pratique, les organes de visualisation (8, 10 et 13) sont des diodes électroluminescentes, de couleur jaune pour la diode (10) qui indique la mise en service du circuit électronique, de couleur verte pour la diode (13) qui indique le raccordement aux bornes (20 et 31) des résistances de test sélectionnées, et de couleur rouge pour la diode (8) qui indique que la limite de température haute est atteinte par le thermostat (4). Les résistances (6, 9 et 11) sont calibrées au niveau de leur valeur ohmique et de leur puissance nominale de manière à limiter le courant dans les diodes électroluminescentes (8, 10 et 13). La diode (2), quant à elle, évite que ces diodes électroluminescentes ne subissent des dommages en cas d'inversion de la polarité des quatre piles (1a,1b,1c et 1d) du générateur (1) lors du montage de ces dernières dans leur logement prévu à cet effet sur le circuit imprimé (33).

Les résistances de test (26 à 30) sont fixées de part et d'autre d'une plaque (34) en matériau conducteur de chaleur, de l'aluminium dans l'exemple de réalisation présenté, et le thermostat (4) est fixé au milieu de celle-ci sur les figures, mais cet emplacement n'est pas limitatif.

Les boutons de commande (3, 14, 15), les organes de visualisation (8, 10, 13), le sélecteur (24), et les bornes femelles de raccordement (20) et (31) sont fixés sur le couvercle du boîtier (32). Les autres organes qui composent le circuit électronique du dispositif selon l'invention présenté en exemple sont installés sur un circuit imprimé (33).

La plaque d'aluminium (34) et le circuit imprimé (33) sont fixés dans le boîtier (32) et maintenus à distance respectable entre eux et avec les autres organes du dispositif selon l'invention présenté en l'exemple à l'aide de quatre vis (35), huit entretoises (36) et quatre écrous (37) ; Les vis (35) étant vissées au fond du boîtier (32) dans des logements prévus à cet effet.

Dans l'exemple de réalisation présenté du dispositif selon l'invention, les résistances (25) à (30) ont été choisies comme telles :
- La résistance (30) est constituée de quatre résistances connectées électriquement en série, trois résistances (30a, 30b, 30c), de caractéristiques nominales 100 Ohms - 50 Watts - 1250 Volts de tension limite, et d'une résistance30d de caractéristiques nominales 150 Ohms - 50 Watts - 1250 Volts de tension limite. La résultante de ce montage équivaut à une résistance dont la valeur ohmique est d'environ 450 Ohms - 150 Watts.
- La résistance (29) est constituée de deux résistances (29a et 29b) connectées en série et dont les caractéristiques nominales de chacune sont 220 Ohms - 50 Watts - 1250 Volts de tension limite. La résultante de ce montage équivaut à une résistance dont la valeur ohmique est d'environ 440 Ohms - 100 Watts.
- La résistance (28) est constituée d'une résistance dont les caractéristiques nominales sont 1200 ohms - 50 Watts - 1250 Volts de tension limite.
- La résistance (27) et constituée d'une résistance dont les caractéristiques nominales sont 2200 Ohms - 50 Watts - 1250 Volts de tension limite.
- La résistance (26) est constituée d'une résistance dont les caractéristiques nominales sont 4700 Ohms - 25 Watts - 500 Volts de tension limite.
- La résistance (25) est constituée d'une résistance dont les caractéristiques nominales sont 33 000 ohms - 7 Watts - 500 Volts de tension au maximum.

La puissance nominale des résistances de valeur ohmique les plus faibles est diminuée jusqu'à 75% environ par rapport à la puissance nominale qu'elles devraient posséder pour subir sans dommage les tests sous la tension nominale de l'appareil.

Dans l'exemple de réalisation présenté du dispositif selon l'invention, la résistance (25) est installée sur le circuit imprimé (33) afin d'utiliser au mieux la place disponible au coeur du dispositif. Cette installation peut être réalisée ainsi sans danger pour les matériels et l'opérateur car la puissance nominale de cette résistance (25) est suffisante pour supporter la tension nominale 500 Volts appliquée aux bornes (20 et 31) du dit dispositif en service continu. Dans l'exemple de réalisation du dispositif selon l'invention, la température nominale du thermostat (4) est de 70 Degrés Centigrades. Tous les organes composant le dit dispositif sont choisis résistants à des températures supérieures à ce seuil de température du thermostat (4).

Le test du bon fonctionnement d'un contrôleur d'isolement connecté sur un réseau électrique sous tension fonctionnant selon le schéma I T peut être réalisé en connectant les bornes (20) et (31) de l'appareil de test au réseau de protection d'une part, et à un quelconque point du réseau électrique sous tension concerné d'autre part, en prenant toutes les précautions d'usage habituellement pratiquées par les personnes averties des risques électriques.

L'opérateur sélectionne ensuite le calibre des résistances de test, à l'aide du sélecteur (24), à une valeur ohmique inférieure au seuil d'alarme réglé sur le contrôleur d'isolement à vérifier.

L'opérateur ferme alors l'interrupteur (3) afin de mettre en service le circuit électronique de commande des moyens de pontage, et l'organe de visualisation (10) se trouve alors excité.

L'opérateur exerce ensuite une pression sur le bouton poussoir (15), ce qui a pour effet de provoquer la connexion des résistances de test sélectionnées entre le réseau électrique sous tension, et le réseau de protection; L'organe de visualisation 13 se trouve alors également excité.

L'opérateur peut alors examiner si le contrôleur d'isolement vérifié fonctionne correctement. C'est à dire vérifier que ce dernier active effectivement l'alarme visuelle et/ou sonore prévue en cas de défaut d'isolement sur le réseau électrique.

Lorsque cet examen est terminé, l'opérateur peut exercer une pression sur le bouton poussoir (14) afin de provoquer la déconnexion des résistances de test sélectionnées d'entre le réseau électrique sous tension et le réseau de protection; Cette manoeuvre provoque alors la désexcitation de l'organe de visualisation (13).

L'opérateur peut ensuite ouvrir l'interrupteur (3) afin de mettre hors service le circuit électronique de l'appareil de test (cette manoeuvre va entraîner la désexcitation de l'organe de visualisation 10), et déconnecter ce dernier du réseau électrique sous tension et du réseau de protection, en prenant toutes les précautions d'usage habituellement pratiquées par les personnes averties des risques électriques.

Si au cours de l'examen du fonctionnement d'un contrôleur d'isolement les résistances de test se trouvent être en danger par rapport à la tension à leurs bornes et à la durée du dit examen, le thermostat (4) va provoquer la déconnexion automatique des résistances de test d'entre le réseau électrique sous tension et le réseau de protection, la désexcitation de l'organe de visualisation (13), et l'excitation de l'organe de visualisation (8).

L'opérateur ne pourra alors plus provoquer la connexion des résistances de test aux bornes (20) et (31) tant que la température de ces résistances de test ne sera pas redescendue sous le seuil de température bas du thermostat (4), et par la même, tant que l'organe de visualisation (8) sera excité.

## Revendications

1. Appareil de test du bon fonctionnement des contrôleurs d'isolement raccordés sur les réseaux électriques sous tension, destiné à être raccordé par l'intermédiaire de ses des deux bornes de connexion (20 et 31) au réseau de protection (PE) d'une part et à un quelconque point du réseau électrique sous tension concerné d'autre part, et équipé entre autre de résistances de test connectables entre les bornes du dit appareil de test (20 et 31)afin de créer un défaut d'isolement apte à exciter l'alarme du contrôleur d'isolement testé, **caractérisé en ce que** les dites résistances de test sont de puissances nominales inférieures aux puissances qu'elles devraient dissiper pour subir sans dommage les mise sous tension nominale de l'appareil de test entre le réseau électrique et le réseau de protection (PE) pendant une durée quelconque, c'est à dire en service continu, et protégées contre ces dits dommages grâce à un organe de détection de seuil prédéterminé (4) apte à provoquer leur déconnexion d'entre les bornes de l'appareil de test (20 et 31) avant qu'elles ne subissent des dommages irréversibles, le temps disponible avant action de cet organe étant suffisant pour apprécier si le contrôleur d'isolement testé active l'alarme prévue en cas de défaut d'isolement sur le réseau électrique.

2. Appareil de test selon la revendication 1 **caractérisé en ce qu'**il peut être doté de moyens de pontage aptes à connecter ou à déconnecter les résistances de test sélectionnées entre les bornes de raccordement(20 et 31) du dit appareil de test.

3. Appareil de test selon la revendication 1 **caractérisé en ce qu'**il peut être doté d'un sélecteur (24) qui permet de sélectionner les résistances de test à connecter aux bornes (20 et 31) de l'appareil de test.

4. Appareil de test selon la revendication 3 **caractérisé en ce que** le sélecteur (24) qui permet de sélectionner les résistances de test est de tension nominale inférieure à la tension nominale du dit appareil de test, le bon fonctionnement du système étant obtenu en utilisant un type de sélecteur doté pour chaque position de plusieurs contacts à action simultanée raccordés en série, dont la somme des tensions nominales de chacun des contacts raccordés en série est supérieure ou égale à la tension nominale de l'appareil de test pour chaque position du sélecteur, et dont la rigidité diélectrique des contacts est nettement supérieure à la tension nominale du dit appareil de test, l'isolement de l'opérateur par rapport au sélecteur étant obtenu en intégrant ce dernier dans un boîtier en matériau isolant et en utilisant un organe de manoeuvre isolant du sélecteur

5. Appareil de test selon la revendication 3 **caractérisé en ce que** le sélecteur (24) qui permet de sélectionner les résistances de test est de tension nominale inférieure à la tension nominale de l'appareil de test, le bon fonctionnement du dispositif étant obtenu en utilisant un sélecteur équipé de deux contacts à action simultanée pour chaque position du sélecteur, ces derniers étant raccordés d'une part en sélection des résistances de test pour la première série de contacts(24b) d'autre part en commande d'ouverture des moyens de pontage qui sont propres à connecter ou à déconnecter entre les bornes de l'appareil de test (20 et 31) les résistances de test sélectionnées pour la deuxième série de contacts, l'isolement de l'opérateur par rapport au sélecteur étant obtenu en intégrant ce dernier dans un boîtier en matériau isolant et en utilisant un organe de manoeuvre isolant du sélecteur.

6. Appareil de test selon la revendication 3 **caractérisé en ce que** le sélecteur (24) qui permet de sélectionner les résistances de test est de tension nominale inférieure à la tension nominale de l'appareil de test, le bon fonctionnement du dispositif étant obtenu en utilisant un sélecteur équipé de contacts dont la rigidité diélectrique est nettement supérieure à la tension nominale du dispositif selon l'invention, et en proscrivant la manoeuvre du dit sélecteur sous tension, l'isolement de l'opérateur par rapport au sélecteur étant obtenu en intégrant ce dernier dans un boîtier en matériau isolant et en utilisant un organe de manoeuvre isolant du sélecteur.

7. Appareil de test selon la revendication 2, **caractérisé en ce que** les moyens de pontage utilisés afin de connecter et déconnecter les résistances de test sélectionnées entre les bornes de l'appareil de test (20 et 31) sont réalisés à l'aide d'un relais équipé, entre autres, de contacts reliés électriquement en série dont la tension nominale de chacun peut être inférieure à la tension nominale de l'appareil de test, le bon fonctionnement du dispositif étant obtenu lorsque la somme des tensions nominales de chaque contact est supérieure ou égale à la tension nominale de l'appareil de test, et lorsque la rigidité diélectrique entre les dits contacts est nettement supérieure à la tension nominale de l'appareil de test.

8. Appareil de test selon la revendication 2 **caractérisé en ce que** les moyens de pontage utilisés afin de connecter ou déconnecter les résistances de test sélectionnées entre les bornes de l'appareil de test (20 et 31) sont réalisés à l'aide de plusieurs relais excités ou désexcités simultanément et dotés de contacts reliés électriquement en série dont la tension nominale de chacun peut être inférieure à la tension nominale de l'appareil de test, le bon fonctionnement du dispositif étant obtenu lorsque la somme des tensions nominales de chacun de ces contacts est supérieure ou égale à la tension nominale de l'appareil de test, et lorsque la rigidité diélectrique entre contacts d'un même relais est nettement supérieure à la tension nominale de l'appareil de test divisée par le nombre de relais qui équipent ces moyens de pontage.

9. Appareil de test selon une des revendications 1 à 2, **caractérisé en ce qu'**il comporte un organe de mise en service (3) du circuit électronique de commande des moyens de pontage, un organe de visualisation (10) qui indique que le dit circuit électronique est en service, un organe de mise en action (15) des moyens de pontage qui assurent la connexion des résistances de test sélectionnées entre les bornes de raccordement du dit appareil de test (20 et 31), un organe de visualisation (13) de la mise en action des dits moyens de pontage, un organe de mise hors action (14) des moyens de pontage qui assurent alors la déconnexion des résistances de test sélectionnées d'entre les bornes de raccordement du dit appareil de test (20 et 31), un organe de visualisation (8) apte à indiquer que le seuil prédéterminé est atteint par les résistances de test.

10. Appareil de test selon l'une des revendications 1 à 9, **caractérisé en ce que** le seuil prédéterminé est une limite haute de température détectée au moyen d'un organe de détection choisi dans l'ensemble (thermostat, fusible thermique, dispositif électronique permettant de détecter une élévation de température des résistances de test )

11. Appareil de test selon la revendication 10, **caractérisé en ce que** la limite haute de température détectée par l'organe de détection est de 70 degrés environ.

12. Appareil de test selon l'une des revendications 9 à 11, **caractérisé en ce que** si au cours de l'examen du fonctionnement d'un contrôleur d'isolement les résistances de test se trouvent être en danger par rapport à la tension à leurs bornes et à la durée dudit examen, le thermostat est apte à provoquer la déconnexion automatique des résistances de test d'entre le réseau électrique sous tension et le réseau de protection, la désexcitation de l'organe de visualisation (13), et l'excitation de l'organe de visualisation (8).

13. Appareil de test selon l'une des revendications 9 à 12, **caractérisé en ce qu'**il est conçu pour qu'un opérateur ne puisse plus provoquer la connexion des résistances de test aux bornes (20) et (31) tant que la température de ces résistances de test ne sera pas redescendue sous le seuil de température bas du thermostat (4), et par la même, tant que l'organe de visualisation (8) sera excité.

14. Appareil de test selon l'une des revendications là 9, **caractérisé en ce que** le seuil prédéterminé est un seuil de tension haute.
